# EUROPEAN PATENT SPECIFICATION

(11) **EP 1 656 737 B1**
(45) Date of publication and mention of the grant of the patent: **08.05.2019**
(21) Application number: 04780328.3
(22) Date of filing: 06.08.2004
(51) Int. Cl.: H03M 13/11, H03M 13/00

(54) **METHOD AND APPARATUS FOR VARYING LENGTHS OF LOW DENSITY PARITY CHECK CODEWORDS**
METHODE UND VORRICHTUNG ZUR ÄNDERUNG DER LÄNGE VON KENNWÖRTER MIT NIEDRIGER DICHTE PARITÄTSKONTROLLE
PROCEDE ET APPAREIL PERMETTANT DE MODIFIER LES LONGUEURS DE MOTS CODES A CONTROLE DE PARITE FAIBLE DENSITE

(30) Priority: 08.08.2003 US 493937 P; 31.03.2004 US 815311
(43) Date of publication of application: 17.05.2006
(73) Proprietor: Intel Corporation, Santa Clara, CA 95054 (US)
(72) Inventor: Xia, Bo, Chandler, AZ 85225 (US); JACOBSEN, Eric, Scottsdale, AZ 85259 (US)
(74) Representative: Rummler, Felix
(86) International application number: PCT/US2004/025473
(87) International publication number: WO 2005/015748

(56) References cited:
- WO-A-01/97387
- WO-A-2004/047307
- KOU Y ET AL: "Low-density parity-check codes based on finite geometries: A rediscovery and new results" IEEE TRANSACTIONS ON INFORMATION THEORY, IEEE INC. NEW YORK, US, vol. 47, no. 7, November 2001 (2001-11), pages 2711-2736, XP002275913 ISSN: 0018-9448
- ELEFTHERIOU E ET AL: "Low-density parity-check codes for digital subscriber lines" ICC 2002. 2002 IEEE INTERNATIONAL CONFERENCE ON COMMUNICATIONS. CONFERENCE PROCEEDINGS. NEW YORK, NY, APRIL 28 - MAY 2, 2002, IEEE INTERNATIONAL CONFERENCE ON COMMUNICATIONS, NEW YORK, NY : IEEE, US, vol. VOL. 1 OF 5, 28 April 2002 (2002-04-28), pages 1752-1757, XP010589787 ISBN: 0-7803-7400-2
- WILSON S G: "Linear block codes" DIGITAL MODULATION AND CODING, XX, XX, 1996, pages 411-425,470, XP002275914
- LU B ET AL: "LDPC-BASED SPACE-TIME CODED OFDM SYSTEMS OVER CORRELATED FADING CHANNELS: PERFORMANCE ANALYSIS AND RECEIVER DESIGN" IEEE TRANSACTIONS ON COMMUNICATIONS, IEEE INC. NEW YORK, US, vol. 50, no. 1, January 2002 (2002-01), pages 74-88, XP001061353 ISSN: 0090-6778
- GALLAGER R G: "LOW-DENSITY PARITY-CHECK CODES" IRE TRANSACTIONS ON INFORMATION THEORY, IEEE INC. NEW YORK, US, January 1962 (1962-01), pages 21-28, XP000992693

## Description

### CROSS-REFERENCE TO RELATED APPLICATIONS.

### BACKGROUND OF THE INVENTION.

Most communications networks are designed to convey multiple communications simultaneously over each individual communication path, for example, a radio frequency (RF) channel or physical connection, using some type of modulation. In recent years, an increasing demand has arisen for efficient and reliable digital data transfers which assure correct data transmissions at as great a data rate as possible. Forward error correction (FEC) codes have been used in some communications systems for this purpose.

Codes are essentially digital data sequences derived from message sequences and used to convey message information. In forward error correction (FEC), information may be encoded to provide the abilities of detection and/or correction of errors occurring in a transmission, for example resulting from a noisy channel. The receiver in a communication system can recover all the information in the codewords by itself and thus coding lends advantages to high speed communication systems and/or those requiring synchronous communications.

Low Density Parity Check (LDPC) codes are a type of FEC block codes which are constructed using a number of simple parity-check relationships shared between the bits in a codeword. An LDPC code (n, k) where n is codeword length and k is the information length, is usually represented by a sparse parity-check matrix H with dimension n * (n-k). The parity check matrix is used as a basis for encoding and decoding LDPC codewords. LDPC codes are well known for their excellent performance in communications systems but due to their block nature, they have thus far not been flexible enough for systems where either information length or codeword length (or both) is variable. Thus a more flexible LDPC coding scheme is desirable.

WO 01/97387 A describes a LDPC code of variable codeword length.

### BRIEF DESCRIPTION OF THE DRAWING.

Aspects, features and advantages of the present invention will become apparent from the following description of the invention in reference to the appended drawing in which like numerals denote like elements and in which:
Fig. 1 is an example matrix showing an example parity check relationship for encoding and decoding information according to various embodiments of the present invention;
Fig. 2 is a flow diagram illustrating a method for encoding variable length LDPC codewords according to one embodiment of the present invention;
Fig. 3 is a flow diagram illustrating a method for encoding variable length LDPC codewords according to another embodiment of the present invention;
Fig. 4 is block diagram of an example communication device according to various aspects of the present invention; and
Fig. 5 is a block diagram of an example communication network including a communication device similar to that in Fig. 4.

### DETAILED DESCRIPTION OF THE INVENTION.

While the following detailed description may describe example embodiments of the present invention in relation to wireless networks, the embodiments of present invention are not limited thereto and, for example, can be implemented using wired systems such as Ethernet or Token ring networks and/or optical networks where suitably applicable.

The following inventive embodiments may be used in a variety of applications including transmitters, receivers and/or transceivers of a radio system, although the present invention is not limited in this respect. Radio systems specifically included within the scope of the present invention include, but are not limited to: wireless local area network (WLAN) systems, wireless metropolitan area network (WMAN) systems and wireless wide area network (WWAN) systems. Related network devices and peripherals such as network interface cards (NICs) and other network adaptors, base stations, access points (APs), gateways, bridges, hubs and cellular radiotelephones are also included. Further, the network systems within the scope of the invention may include cellular radiotelephone systems, satellite systems, personal communication systems (PCS), two-way radio systems, one-way pages, two-way pagers, personal computers (PC), personal digital assistants (PDA), personal computing accessories (PCA) and all future arising systems which may be related in nature and to which the principles of the invention could be suitably applied.

An LDPC code is a message encoding technique defined by a sparse parity check matrix. The message to be sent is encoded using a generator matrix or the sparse parity check matrix and when it reaches its destination, it is decoded using a related sparse parity check matrix.

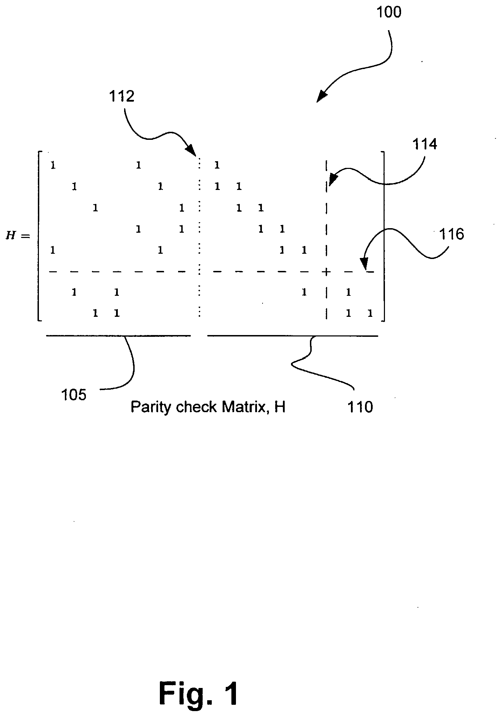

Turning to Fig. 1 a sample parity check matrix 100 H is shown for a (14, 7) code of total codeword length n=14 and information length k=7. The columns of matrix 100 represent code bits and the rows represent parity check equations. As shown, matrix 100 includes a data bit field 105 left of vertical line 112 and a parity bit field 110 right of vertical line 112.

Conventionally, each LDPC codeword has the same length as others in a block since the block is typically encoded using the same parity check matrix for each codeword. However, according to one embodiment of the present invention, a family of different sized LDPC codes (H matrices) may be used for encoding/decoding different length combinations. For each different size codeword, a corresponding size matrix is used for encoding and decoding. This approach, however, may only be feasible when the number of length combination is relatively small.

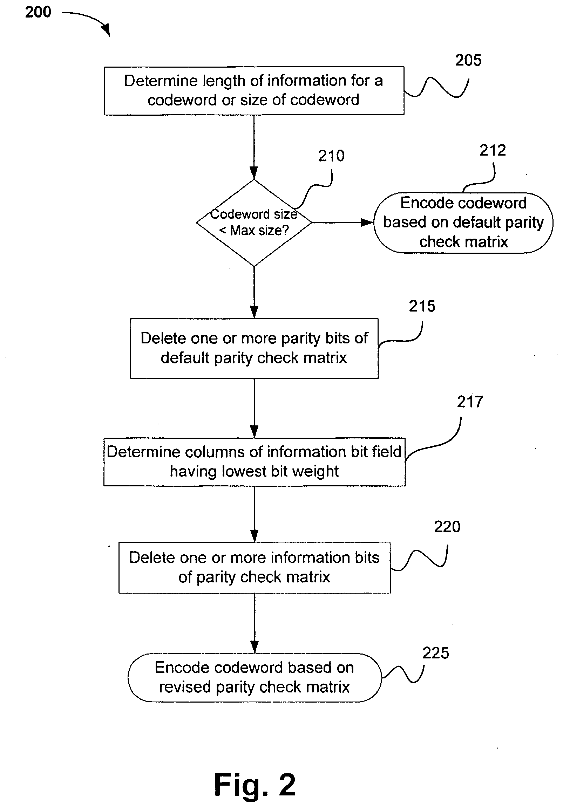

In another approach, turning to Fig. 2, a method 200 for encoding variable length codewords may include determining 205 a length of information to encode in a codeword (and/or determining the size of codeword to be used). If the determined codeword size is less than 210 than a specified size of a default parity check matrix, method 200 may include deleting 215 one or more parity bits of the default matrix or "mother code" to correspond to the size of codeword needed. Method 200 may additionally or alternatively include deleting 220 one or more information bits of the default matrix. A codeword is either encoded 212 based on the default matrix or encoded 225 based on the adjusted matrix.

Determining the size of the codeword may simply involve identifying a length of information to be sent in each codeword. In one example embodiment, for WLAN, each single medium access control (MAC) service data unit (MSDU) (or MAC protocol data unit (MPDU)) covered by a single CRC checksum is preferably encoded as one block code. In other words, the data boundary of an MSDU is respected by the encoder. The MSDU length field indicated in a PLCP header, in this embodiment, is all that is needed for identifying the length of the information to be coded.

The size of the default matrix or "mother code" may be adjusted to accommodate various length combinations by deleting or puncturing code bits. As shown in matrix 100 (Fig. 1), when encoded systematically, the last n-k code bits correspond to parity bits of a codeword and "deleting" or "puncturing" 215 these parity bits is interpreted as erasing these bits in the decoder or setting them as unknown. For a family of low-complexity encodeable parity matrices in the form of H=[H₁ | P], where H1 is a low density matrix and P is a lower triangular square matrix, deleting x parity bits may be performed by deleting the last x columns and the last x rows of the H matrix 100 (Fig. 1). As shown by dashed lines 114, 116 in Fig. 1, the original (14, 7) mother code is punctured by 2 parity bits into a (12, 7) code.

Deleting information bits 220 (in addition to or in lieu of puncturing 215 parity bits) may be performed by deleting columns in data bit field 105 (Fig. 1). Selection of information bit columns for deletion, however, may impact code performance, particularly when accompanied by parity bit puncturing. As shown in the example of Fig. 1, when the two rows under line 116 are deleted, the fourth column in matrix 100 will no longer have any bits remaining (e.g., no "1s" are present in the fourth column of the resized matrix defined by dashed lines 114 and 116). The fourth column is thus no longer represented by any parity check equations in the resized matrix. Accordingly, since the fourth column is the weakest link in resizing matrix 100, it could be beneficial to delete the fourth column first when deleting information bits.

Generally there are two types of LDPC codes, regular codes and irregular codes. A regular code is represented by a matrix where the column weight for the data bit field is equal for all columns. Conversely, an irregular code is represented by a matrix where column weights may be different from one another. If information bits are to be deleted, method 200 may optionally include identifying or determining 217 one or more of the data bit columns in the mother code having the lowest total bit weight and deleting 220 the one or more columns of the code having the lowest weight. If a regular code is used, the columns may have the same weight unless one or more parity bits are punctured or deleted.

Referring back to Fig. 1, to derive a (9,4) code from the (12,7) code (e.g., the code after the two parity bits are punctured from the default (14, 7) code), the second, third and fourth columns may be deleted since those columns have the lowest column weight (i.e., number of '1's) after parity bit puncturing. In order to implement this option, however, the column weight distribution may have to be obtained or determined on every instance. This distribution however, may vary with the derived code, i.e., the number of rows deleted. In real-time applications, obtaining this distribution for every case and then selecting columns for deletion on-the-fly may be an inefficient time-consuming procedure.

Accordingly, in certain embodiments of the present invention, various thresholds may be set to obtain practically achievable results. For example, assume a mother code of (2000, 1600); that is, the H matrix is of size 400 x 2000 for maximum code lengths of 2000 bits of which 1600 may be information bits.

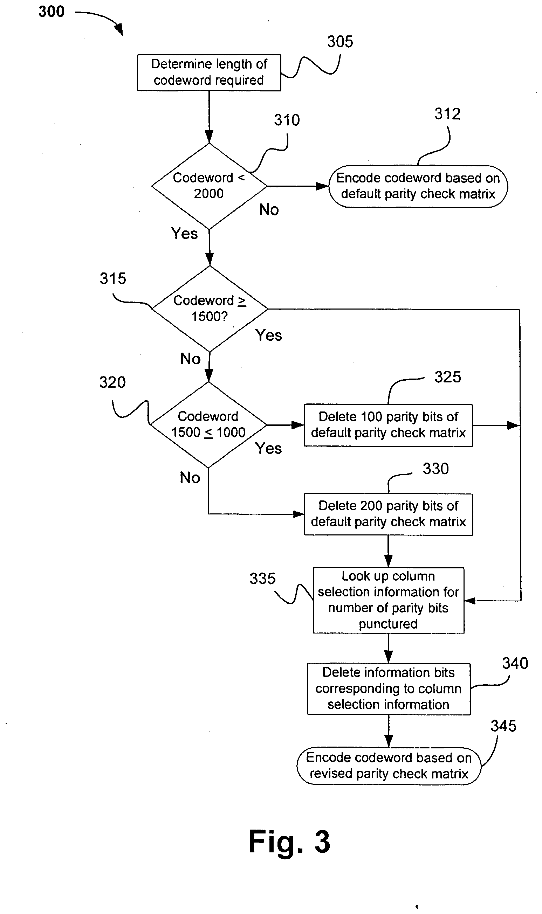

Turning to Fig. 3, a method 300 for encoding may include using threshold values for handling varying codeword lengths, although the inventive embodiments are not limited to any number of threshold values or code lengths. In one example implementation, two thresholds may be set at 1500 and 1000 although it is entirely discretionary. The length of the code is determined 305 and if the code meets the maximum of the mother code (i.e. 2000) the information is encoded 312 using the full size default parity check matrix as previously discussed.

When the desired code length is less than 2000 but above 1500 (315), no parity bits are punctured and only information bits are deleted 340 as necessary to accommodate the codeword size. As discussed previously, one or more columns of information bits may be deleted according to a column weight distribution of bits as desired (e.g., if an irregular code is used with no parity bit puncturing).

In the case of regular codes and no parity bit puncturing, the columns may theoretically have equal weight and thus there may be no need to choose specific information bit columns for deletion since it may not impact code performance. In any event, information for selecting which columns to delete could be previously stored and retrieved 335 such as in a look-up table or other memory.

For code lengths within the thresholds 1000 and 1500 (320), a number of parity bits may be punctured 325, for example 100 parity bits, and information bits can be deleted according to previously stored column selection information for the case when the last 100 rows are to be deleted due to parity bit puncturing.

For code lengths less than 1000 a greater number of parity bits such as 150 or 200 could be punctured 330 and previously stored column selection information for deleting the lowest weighted column(s) of information bits when this many parity bits are punctured can be retrieved 335. The information may then be coded 345 based on the revised parity check matrix. In this manner, only a relatively small amount of information would need to be stored in prior and the complexity of the corresponding encoding system may be reduced while still achieving a reasonable amount of flexibility. Decoding may be performed in a substantially reciprocal manner as that described above using similarly configured algorithms for the decoder.

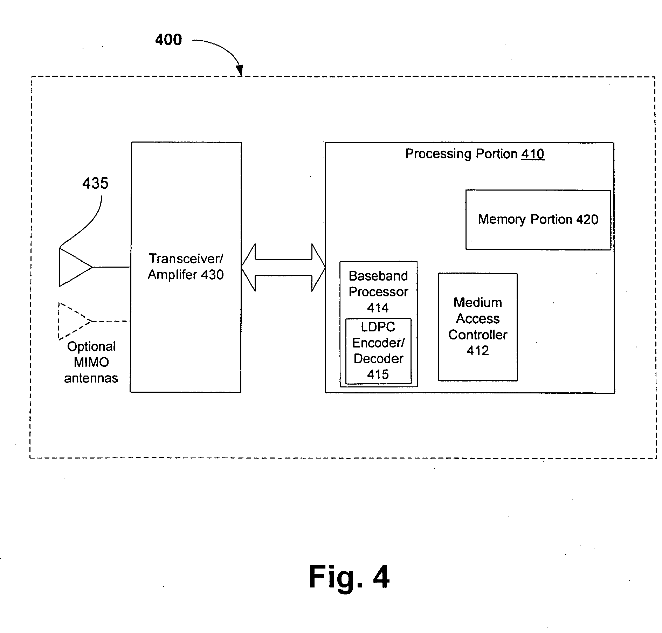

Turning to Fig. 4, an example communication device 400 using forward error correction (FEC) with variable length LDPC FEC may generally include a code processing portion 410, and a memory portion 420 accessible by processing portion 410. Device 400 may also optionally include a transceiver/amplifier portion 430 and/or one or more antennas 435. In certain example embodiments, coded information is transmitted/received wirelessly using OFDM modulation and demodulation techniques compatible with one or more Institute for Electrical and Electronic Engineers (IEEE) 802.11 standards for wireless local area networks (WLANs), although the inventive embodiments are not limited in this respect. (Note: two antennas are shown in Fig. 4 for optional Multiple Input Multiple Output (MIMO) implementations).

Memory portion 420 may include one or more fixed, removable, internal or external memories and capable of storing machine readable code and/or other data which may be used by processing portion 410, for example to perform one or more of the variable length LDPC encoding/decoding processes described herein. Processing portion 410 and/or memory portion 420 may be any single component or combination of components for performing these functions.

Processing portion 410 may be configured to perform digital communication functions such as a medium access control 412 and/or baseband processing 414. In one example implementation, an LDPC encoder/decoder 415 configured to perform one of the previously described variable length encoding methods is integrated, along with an optional digital demodulator (not separately shown), as part of a digital baseband processor 414. The inventive embodiments are however not limited in this respect. Additional elements, such as one or more analog to digital converters (ADC), digital to analog converters (DAC), a memory controller, a digital modulator and/or other associated elements, may also be included as part of device 400.

In certain embodiments, processing portion 410 and/or memory portion 420 may be implemented using one or more programmable devices such as a microprocessor, Digital Signal Processor (DSP), microcontroller or field programmable gate array. Additionally and/or alternatively, various elements of processing portion 410 may be implemented using discrete circuit components or as one or more application specific integrated circuits (ASICs). Other implementations may also be possible and the principles of the inventive embodiments are not limited to any specific hardware, software or firmware implementation.

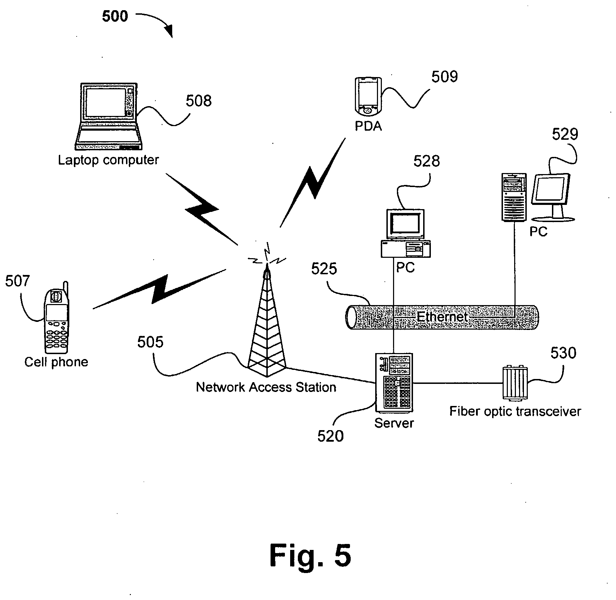

Referring to Fig. 5, an example communication network 500 using variable length LDPC codes for forward error correction (FEC), and for which the inventive embodiments may be adapted, may include one or more wireless network access stations 505 and one or more wireless user stations 507-509. Wireless network access station 505 may be any device or combination of devices which facilitate network access to wireless user stations 507-509 via electromagnetic waves including for example, a wireless local area network (WLAN) access point (AP), a wireless wide area network (WWAN) AP, a cellular telephone base station and the like. User stations 507-509 may be any device or component of such device configured to communicate with access station 505, including for example, a cellular telephone 507, a laptop computer 508, a personal digital assistant 509 or other communication or computing devices and/or their RF interfaces.

Network access station 505 may include and/or be communicatively coupled to a network processor 520 such as a network server, telephone circuit switch, or any other packet or frame-based network switch and/or information control device. Network 500 may additionally or alternatively include physically connected components such as those used in a wired network (e.g., Ethernet 525 and related user stations 528, 529) or a fiber optic network (e.g., fiber optic transceiver 530). Accordingly, any device in network 500 using FEC may suitably include encoding/decoding components arranged to perform the variable length LDPC coding methods described herein.

## Claims

1. A method of encoding information by a wireless communication device comprising:
encoding information into one or more variable length low density parity check codewords; **characterised by**
determining the size of the codewords and, if the codeword size is more than a predetermined size of a default parity check matrix, adjusting a size of the default parity check matrix by selecting one or more columns of the default parity check matrix having a lowest bit weight and deleting the selected columns; and
encoding the codewords based on the adjusted parity check matrix.

2. The method of claim 1 wherein the parity check matrix has a size corresponding to a size of information to be encoded.

3. The method of claim 1 further comprising:
transmitting the one or more variable length codewords via an air interface using orthogonal frequency division multiplexing.

4. The method of claim 1 further comprising: sending one or more of the variable length codewords to a network device, wherein the network device comprises a wireless local area network access point.

5. The method of claim 1 further comprising sending one or more of the variable length codewords to a network device.

6. A method of decoding information by a wireless communication device, comprising:
receiving a data unit including one or more variable length low density parity check codewords from a network device; **characterised by**
decoding the one or more variable length low density parity check codewords based on a parity check matrix having one or more columns deleted, the deleted columns corresponding to a lowest bit weight.

7. The method of claim 6 wherein the parity check matrix has a size corresponding to a length of the codeword.

8. A wireless communication device (400) comprising:
a low density parity check encoder (415) configured to encode information into varying length low density parity check codewords using different sized parity check matrices by
determining the size of the codewords and, if the codeword size is more than a predetermined size of a default parity check matrix, adjusting a size of the default parity check matrix by selecting one or more columns of the default parity check matrix having a lowest bit weight and deleting the selected columns, and
encoding the codewords based on the adjusted parity check matrix.

9. The wireless communication device of claim 8 wherein the size of the parity check matrix corresponds to a length of information to encode in each codeword.

10. The wireless communication device of claim 8 further comprising:
a low density parity check decoder (415) configured to decode varying length low density parity check codewords of a received block code using different sized parity check matrices.

11. A wireless communication system comprising:
a mobile unit (400) including, a radio frequency - RF - transceiver (430); and
an encoder (415) in accordance with claim 8 communicatively coupled to the RF transceiver and adapted to encode information into one or more variable length low density parity check codewords.

12. The wireless communication system of claim 11 wherein the parity check matrix has a size corresponding to a length of information for each codeword.

13. The wireless communication system of claim 11 further comprising a wireless local area network access point.

14. The wireless communication system of claim 11 further comprising one or more antennas (435) coupled to the RF transceiver.

## Patentansprüche

1. Verfahren zum Codieren einer Information durch eine Drahtloskommunikationsvorrichtung, umfassend:
Codieren einer Information in ein oder mehrere Codewörter mit variabler Länge zur Paritätsprüfung niedriger Dichte; **gekennzeichnet durch** Bestimmen der Größe der Codewörter und, wenn die Codewortgröße mehr als eine vorbestimmte Größe einer voreingestellten Paritätsprüfungsmatrix beträgt, Einstellen einer Größe der voreingestellten Paritätsprüfungsmatrix durch Auswählen von einer oder mehreren Spalten der voreingestellten Paritätsprüfungsmatrix mit einem niedrigsten Bit-Gewicht und Löschen der ausgewählten Spalten; und
Codieren der Codewörter basierend auf der eingestellten Paritätsprüfungsmatrix.

2. Verfahren nach Anspruch 1, wobei die Paritätsprüfungsmatrix eine Größe aufweist, die einer Größe der zu codierenden Information entspricht.

3. Verfahren nach Anspruch 1, ferner umfassend:
Übertragen des einen oder der mehreren Codewörter mit variabler Länge über eine Luftschnittstelle unter Verwendung von orthogonalem Frequenzteilungsmultiplexen.

4. Verfahren nach Anspruch 1, ferner umfassend:
Senden von einem oder mehreren der Codewörter mit variabler Länge an eine Netzwerkvorrichtung, wobei die Netzwerkvorrichtung einen Zugriffspunkt zu einem drahtlosen lokalen Netzwerk umfasst.

5. Verfahren nach Anspruch 1, ferner umfassend das Senden von einen oder mehreren der Codewörter mit variabler Länge an eine Netzwerkvorrichtung.

6. Verfahren zum Decodieren einer Information durch eine Drahtloskommunikationsvorrichtung, umfassend:
Empfangen einer Dateneinheit, die ein oder mehrere Codewörter mit variabler Länge zur Paritätsprüfung niedriger Dichte beinhaltet, von einer Netzwerkvorrichtung; **gekennzeichnet durch**
Decodieren des einen oder der mehreren Codewörter mit variabler Länge zur Paritätsprüfung niedriger Dichte basierend auf einer Paritätsprüfungsmatrix, in der eine oder mehrere Spalten gelöscht wurden, wobei die gelöschten Spalten einem niedrigsten Bit-Gewicht entsprechen.

7. Verfahren nach Anspruch 6, wobei die Paritätsprüfungsmatrix eine Größe aufweist, die einer Länge des Codeworts entspricht.

8. Drahtloskommunikationsvorrichtung (400), umfassend:
einen Codierer zur Paritätsprüfung niedriger Dichte (415), der dafür ausgelegt ist, eine Information in Codewörter mit variierender Länge zur Paritätsprüfung niedriger Dichte unter Verwendung unterschiedlich großer Paritätsprüfungsmatrices zu codieren durch
Bestimmen der Größe der Codewörter und, wenn die Codewortgröße mehr als eine vorbestimmte Größe einer voreingestellten Paritätsprüfungsmatrix beträgt, Einstellen einer Größe der voreingestellten Paritätsprüfungsmatrix durch Auswählen von einer oder mehreren Spalten der voreingestellten Paritätsprüfungsmatrix mit einem niedrigsten Bit-Gewicht und Löschen der ausgewählten Spalten, und
Codieren der Codewörter basierend auf der eingestellten Paritätsprüfungsmatrix.

9. Drahtloskommunikationsvorrichtung nach Anspruch 8, wobei die Größe der Paritätsprüfungsmatrix einer Länge einer in jedem Codewort zu codierenden Information entspricht.

10. Drahtloskommunikationsvorrichtung nach Anspruch 8, ferner umfassend:
einen Decoder zur Paritätsprüfung niedriger Dichte (415), der dafür ausgelegt ist, Codewörter mit variierender Länge zur Paritätsprüfung niedriger Dichte eines empfangenden Blockcodes unter Verwendung unterschiedlich großer Paritätsprüfungsmatrices zu decodieren.

11. Drahtloskommunikationssystem, umfassend:
eine Mobileinheit (400), beinhaltend einen Hochfrequenz-HF-Sendeempfänger (430); und
einen Codierer (415) nach Anspruch 8, der kommunikativ mit dem HF-Sendeempfänger gekoppelt ist und dafür eingerichtet ist, eine Information in ein oder mehrere Codewörter mit variabler Länge zur Paritätsprüfung niedriger Dichte zu codieren.

12. Drahtloskommunikationssystem nach Anspruch 11, wobei die Paritätsprüfungsmatrix eine Größe aufweist, die einer Informationslänge für jedes Codewort entspricht.

13. Drahtloskommunikationssystem nach Anspruch 11, ferner umfassend einen Zugriffspunkt zu einem drahtlosen lokalen Netzwerk.

14. Drahtloskommunikationssystem nach Anspruch 11, ferner umfassend eine oder mehrere Antennen (435), die mit dem HF-Sendeempfänger gekoppelt sind.

## Revendications

1. Procédé de codage d'informations par un dispositif de communications sans fil comprenant l'étape consistant à :
coder des informations dans un ou plusieurs mots de code avec contrôle de parité à faible densité et de longueur variable ; **caractérisé par** les étapes consistant à :
déterminer la taille des mots de code et, si la taille du mot de code est supérieure à une taille prédéterminée d'une matrice de contrôle de parité par défaut, ajuster une taille de la matrice de contrôle de parité par défaut en sélectionnant une ou plusieurs colonnes de la matrice de contrôle de parité par défaut ayant le poids binaire le plus bas et en supprimant les colonnes sélectionnées ; et
coder les mots de code en fonction de la matrice de contrôle de parité ajustée.

2. Procédé selon la revendication 1, dans lequel la matrice de contrôle de parité a une taille correspondant à une taille d'informations à coder.

3. Procédé selon la revendication 1, comprenant en outre l'étape consistant à :
transmettre le ou les mots de code de longueur variable par l'intermédiaire d'une interface hertzienne utilisant un multiplexage par répartition orthogonale de la fréquence.

4. Procédé selon la revendication 1, comprenant en outre l'étape consistant à :
envoyer un ou plusieurs mots de code de longueur variable à un dispositif de réseau, dans lequel le dispositif de réseau comprend un point d'accès de réseau local sans fil.

5. Procédé selon la revendication 1, comprenant en outre l'étape consistant à envoyer un ou plusieurs mots de code de longueur variable à un dispositif de réseau.

6. Procédé de décodage d'informations par un dispositif de communications sans fil, comprenant l'étape consistant à :
recevoir une unité de données comprenant un ou plusieurs mots de code de contrôle de parité à faible densité de longueur variable provenant d'un dispositif de réseau ; **caractérisé par** l'étape consistant à :
décoder le ou les mots de code de contrôle de parité à faible densité de longueur variable sur la base d'une matrice de contrôle de parité ayant une ou plusieurs colonnes supprimées, les colonnes supprimées correspondant au poids binaire le plus faible.

7. Procédé selon la revendication 6, dans lequel la matrice de contrôle de parité a une taille correspondant à une longueur du mot de code.

8. Dispositif de communication sans fil (400), comprenant :
un codeur de contrôle de parité à faible densité (415) configuré pour coder des informations en mots de code de contrôle de parité à faible densité de longueur variable à l'aide de matrices de contrôle de parité de tailles différentes, en effectuant les étapes consistant à
déterminer la taille des mots de code et, si la taille du mot de code est supérieure à une taille prédéterminée d'une matrice de contrôle de parité par défaut, ajuster une taille de la matrice de contrôle de parité par défaut en sélectionnant une ou plusieurs colonnes de la matrice de contrôle de parité par défaut ayant le poids binaire le plus bas et en supprimant les colonnes sélectionnées, et
coder les mots de code en fonction de la matrice de contrôle de parité ajustée.

9. Dispositif de communications sans fil selon la revendication 8, dans lequel la taille de la matrice de contrôle de parité correspond à une longueur d'informations à coder dans chaque mot de code.

10. Dispositif de communications sans fil selon la revendication 8, comprenant en outre :
un décodeur avec contrôle de parité à faible densité (415) configuré pour décoder des mots de code de contrôle de parité à faible densité de longueur variable d'un code de blocs reçu à l'aide de matrices de contrôle de parité de tailles différentes.

11. Système de communications sans fil comprenant :
une unité mobile (400) comprenant un émetteur-récepteur à fréquence radio (RF - radio frequency) (430) ;
et un codeur (415) selon la revendication 8, couplé en communication avec l'émetteur-récepteur RF et conçu pour coder des informations en un ou plusieurs mots de code de contrôle de parité à faible densité et de longueur variable.

12. Système de communications sans fil selon la revendication 11, dans lequel la matrice de contrôle de parité a une taille correspondant à une longueur d'informations pour chaque mot de code.

13. Système de communications sans fil selon la revendication 11, comprenant en outre un point d'accès au réseau local sans fil.

14. Système de communications sans fil selon la revendication 11, comprenant en outre une ou plusieurs antennes (435) couplées à l'émetteur-récepteur RF.
